Europäisches Patentamt

European Patent Office

Office européen des brevets

(19)

(11) **EP 1 066 677 B1**

(12) **EUROPEAN PATENT SPECIFICATION**

(45) Date of publication and mention
of the grant of the patent:
**30.11.2005 Bulletin 2005/48**

(21) Application number: **99938020.7**

(22) Date of filing: **03.03.1999**

(51) Int Cl.$^7$: **H03D 3/00**

(86) International application number:
**PCT/GB1999/000629**

(87) International publication number:
**WO 1999/045635 (10.09.1999 Gazette 1999/36)**

(54) **ELECTRONIC CIRCUITS**

ELEKTRONISCHE SCHALTUNGEN

CIRCUITS ELECTRONIQUES

(84) Designated Contracting States:
**DE FR GB IT**

(30) Priority: **03.03.1998 GB 9804354**

(43) Date of publication of application:
**10.01.2001 Bulletin 2001/02**

(73) Proprietor: **The Court of the University of Paisley
Paisley, PA1 2BE (GB)**

(72) Inventors:
• **PETTIGREW, Archibald, McGilvray
Kilmacolm Renfrewshire PA13 4PH (GB)**
• **MOIR, Thomas, James
Paisley PA2 9HE (GB)**

(74) Representative: **McKechnie, Neil Henry et al
Kennedys Patent Agency Limited
185 St Vincent Street
Glasgow G2 5QD (GB)**

(56) References cited:
**WO-A-97/20397          US-A- 5 341 106**

• **PETTIGREW A: "DEMODULATION A NEW
APPROACH" ELECTRONICS WORLD AND
WIRELESS WORLD, vol. 101, no. 1717, 1
December 1995, pages 1026-1031, XP000548985**
• **PATENT ABSTRACTS OF JAPAN vol. 005, no.
179 (E-082), 17 November 1981 & JP 56 106434
A (SONY CORP), 24 August 1981**
• **PETTIGREW A M ET AL: "COHERENT
DEMODULATION OF DSSC WITHOUT PILOT
TONE USING THE AMPLITUDE-LOCKED LOOP"
JOURNAL OF THE AUDIO ENGINEERING
SOCIETY, vol. 41, no. 12, 1 December 1993,
pages 998-1007, XP000514962**

## Description

This invention relates to electronic circuits and more particularly to the demodulation of frequency modulated (fm) radio signals.

Whereas electronic circuits for the demodulation of fm signals have been known since the use of fm for radio broadcasting began in the nineteen thirties, there has been a major problem with all existing demodulators, namely, that if two fm transmissions reach the receiver at the same carrier frequency and amplitude, mutual destruction of both transmissions occurs and all intelligibility is lost.

This is a fundamental property of fm demodulators which use saturating circuits prior to the fm demodulator to remove amplitude noise effects from disturbing the wanted signal.

This effect is called co-channel interference especially when the second interfering transmission is a different station. There are four other types of similar interference which result in complete loss of signal.

The first type is called multipath transmission when a delayed version of the same signal is received at the antenna.

The second type is called quasi-sync transmission when the same message is being transmitted on the same frequency but from another transmitter location. At the overlap of the reception, all intelligibility is lost.

The third type is called self-jamming or deliberate-jamming when an unmodulated carrier is transmitted at equal amplitude to the desired modulated carrier. This commonly occurs in military circumstances including laser Dopplerimetry.

The fourth type is called the threshold condition, when the signal is very weak relative to general noise levels. There is a disproportionate increase in demodulated noise levels which causes loss of intelligibility.

These problems exist for all of fm transmissions whether in an analogue or digital format and include spread spectrum technologies.

Demodulation techniques are known which mitigate the first and second types of interference, ie multipath and quasi-sync. In these circuits, the output is the sum of the two carriers and there is no requirement to separate the two carriers since the same information is carried by them both. However, these known techniques are not suitable for separating a pair of independently modulated co-channel interfering carriers, that is, two carriers of similar strength (1-15dB difference) and having the same or similar carrier frequency. The document "PETTIGREW A: 'DEMODULATION A NEW APPROACH' ELECTRONICS WORLD AND WIRELESS WORLD, vol. 101, no. 1717, 1 December 1995, pages 1026-1031, XP000548985" discusses such a demodulation method involving an amplitude-locked loop used in conjunction with a phase-locked loop.

It is an object of the present invention to provide a method and apparatus for minimising and, in some cases, eliminating the aforementioned problems from fm demodulators.

This object is achieved by the method according to claim 1 and the corresponding circuit according to claim 9.

Embodiments of the present invention will now be described, by way of example, with reference to the accompanying drawings, in which:-

Fig. 1 is a block diagram of the initial stage of the circuit of the invention;
Fig. 2 is a block diagram of the denominator function generator stage;
Fig. 3 is a block diagram of the numerator function generator stage;
Fig. 4 are waveforms of the different signals of the block diagrams of Figs 1 to 3;
Fig. 5 is a block diagram of the amplitude-locked loop (ALL) circuit for generating the quotient function of the invention;
Fig. 6 are waveforms of the signals of the circuit of Fig. 5.
Fig. 7 is a block diagram of a phase-locked loop used in the circuit of the invention;
Fig. 8 is a block diagram illustrating the dominant and sub-dominant channels of the circuit of the invention; and
Figs 9, 10 and 11 illustrate waveforms of the circuit of Fig. 8.

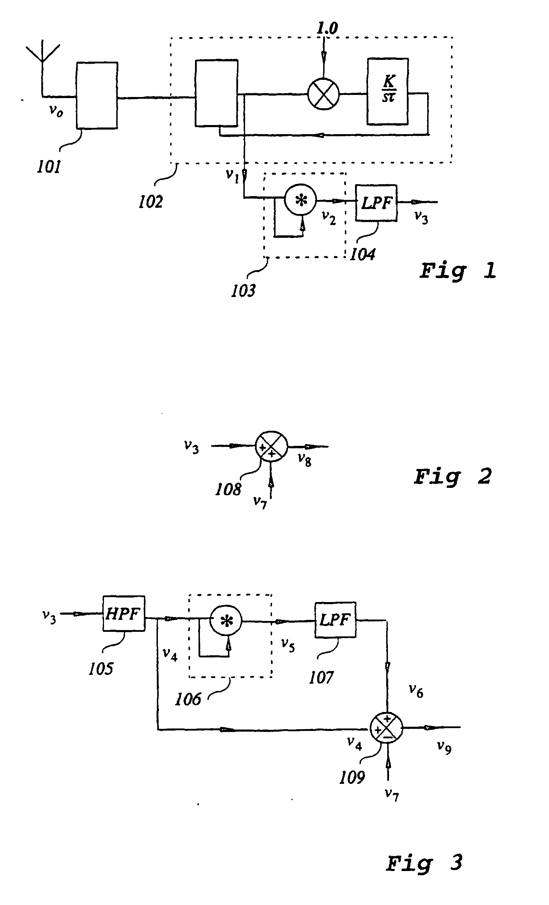

Referring to Fig. 1, a raw received co-channel carrier $v_0$ is passed through a r.f./i.f. stage 101 and through an automatic gain control circuit (AGC) 102 to give $v_1$ which is termed the co-channel carrier.

$$v_0 = \sqrt{1 + 2m\cos\omega_d t + m^2}\cos(\omega_c t + \beta\omega_m \cos\omega_m t)$$

where m is the ratio of the interfering carrier to the wanted carrier;
$\omega_c$ is the angular frequency of the wanted carrier;
$\omega_m$ is the modulation frequency;
$\omega_d$ is the difference frequency between the wanted carrier and the interfering carrier; and

$\beta$ is the depth of modulation.

$$v_1 \text{ is thus } \frac{\sqrt{1 + 2m\cos\omega_d t + m^2}}{\sqrt{1 + m^2}} \cos(\omega_c t + \beta\omega_m\cos\omega_m t)$$

The co-channel carrier $v_1$ is passed to a first pure squaring circuit 103 to give $v_2$ termed the pure squared received co-channel carrier, where

$$v_2 = \frac{1 + 2m\cos\omega_d t + m^2}{1 + m^2}\cos^2(\omega_c t + \beta\omega_m\cos\omega_m t)$$

$v_2$ is then passed through a low pass filter 104 to give a filtered squared carrier $v_3$, where

$$v_3 = \frac{1 + 2m\cos\omega_d t + m^2}{1 + m^2}$$

If m' is defined as

$$\frac{2m}{1 + m^2}$$

then $v_3$ becomes

$$1 + m' \cos\omega_d t$$

Referring now to Fig. 2, the filtered squared signal $v_3$ is added to a small dc offset $v_7$ in adder 108 to give a denominator function, signal $v_8$, where

$$v_8 = 1 + m' \cos\omega_d t + v_{offset}$$

Referring to Fig. 3, $v_3$ is passed to high pass filter 105 to remove the dc content to give $v_4$, where

$$v_4 = m' \cos\omega_d t$$

$v_4$ is then passed to a second pure squaring circuit 106 to give $v_5$, termed the twice squared co-channel carrier, where

$$v_5 = m'^2\cos^2\omega_d t$$

$v_5$ is passed through low pass filter 107 to give a filtered twice squared signal, where

$$v_6 = m'^2$$

Adder 109 serves to add signal $v_6$, signal $v_4$ and subtract the dc offset $v_7$ to give a numerator function $v_9$, where

$$v_9 = m'^2 + m' \cos\omega_d t - v_{offset}$$

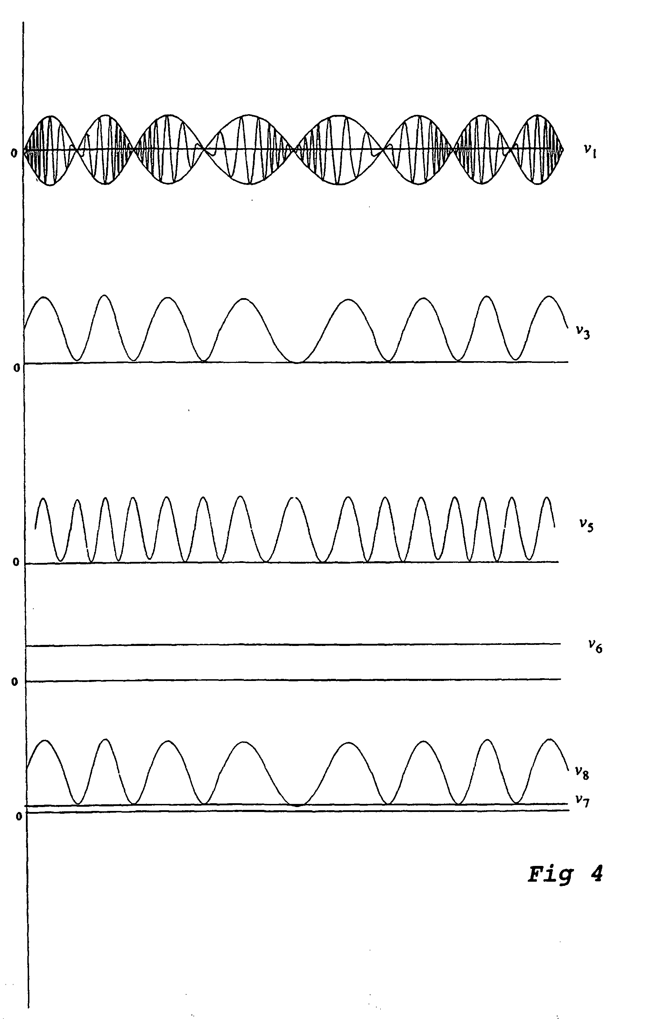

The main waveforms of the signals appearing in the circuits of Figs 1 to 3 are illustrated in Fig. 4.

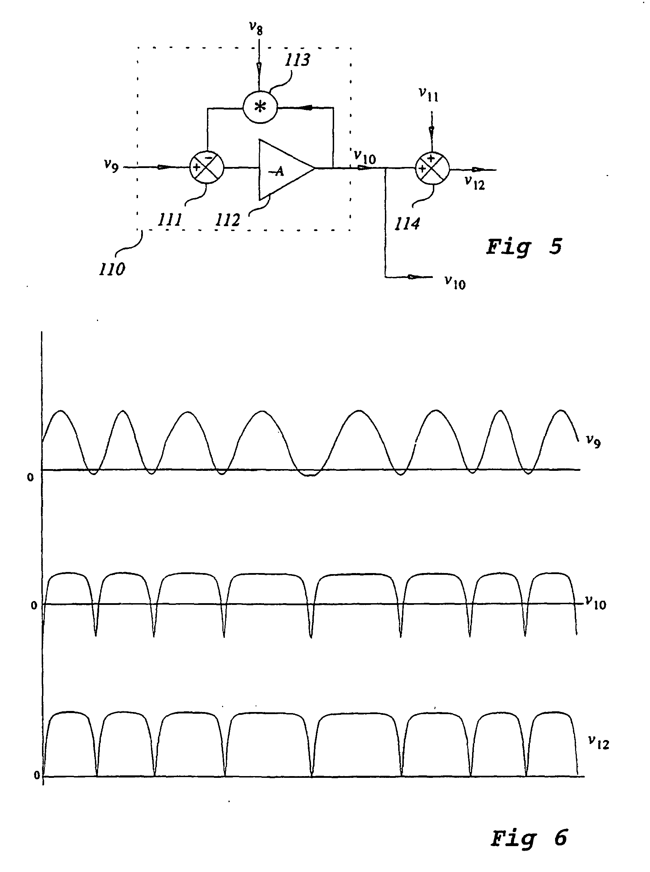

The denominator function $v_8$ from the circuit of Fig. 2 and the numerator function $v_9$ from the circuit of Fig. 3 are processed as follows, with reference to Fig. 5.

The denominator function $v_8$ and the numerator function $v_9$ are processed in an amplitude-locked loop (ALL) circuit 110. The ALL circuit 110 comprises an adder 111, an operational amplifier 112 and a multiplier 113. The output of the ALL 110 is a quotient function $v_{10}$ obtained by dividing the numerator function $v_9$ by the denominator function $v_8$, to give

$$v_{10} = \frac{m'^2 + m' \cos\omega_d t - v_{offset}}{1 + m' \cos\omega_d t + v_{offset}}$$

The quotient function $v_{10}$ is passed to an adder 114 to which there is also input a dc signal $v_{11}$

In a normalised system, the signal $v_{11}$ has a value of 1 volt. $v_{10}$ and $v_{11}$ combine to give a signal $v_{12}$, where $v_{12}$ is defined as $v_{10}+1$

thus

$$v_{12} = \frac{1 + 2m' \cos\omega_d t + m'^2}{1 + m' \cos\omega_d t + v_{offset}}$$

The main waveforms of the signals appearing in the circuit of Fig. 5 are illustrated in Fig. 6.

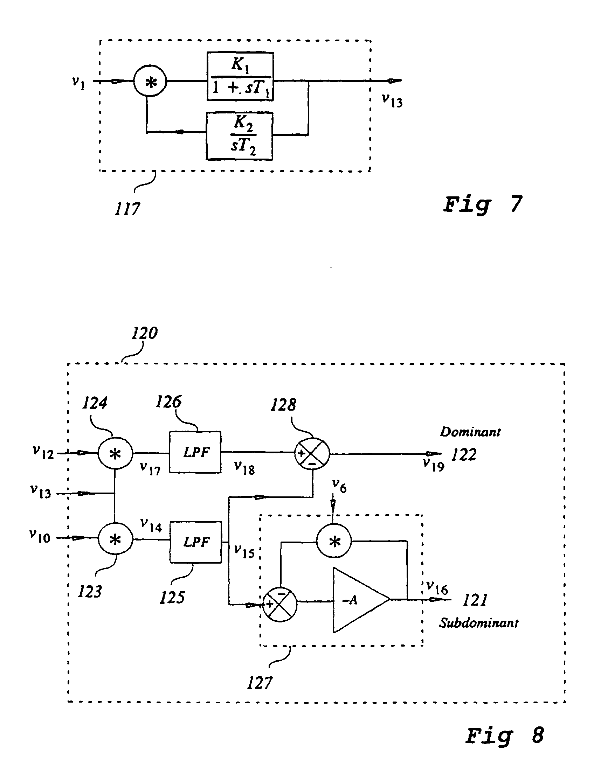

The signals $v_{10}$ and $v_{12}$ are used to condition an fm demodulator as illustrated in Fig. 8.

Referring now to Fig. 7, a PLL demodulator 117, the input to which is the stabilised output of the AGC circuit 102 of Fig. 1, that is, the co-channel carrier $v_1$, produces an output $v_{13}$ being a combination of the dominant carrier and the subdominant carrier, the dominant being an unmodulated carrier and the subdominant carrier being a modulated carrier.

Output $v_{13}$ can be expressed as

$$v_{13} = \frac{m^2 + m\cos\omega_d t}{(1 + 2m\cos\omega_d t + m^2)} \beta\omega_m \cos\omega_m t$$

Referring now to Fig. 8, the fm demodulator comprises a subdominant channel 121 and a dominant channel 122.

The subdominant channel 121 comprises a multiplier 123 fed by signal $v_{10}$ and signal $v_{13}$. The output of the multiplier 123 (signal $v_{14}$) is fed through a low pass filter 125 to give a signal $v_{15}$ being the recovered sub-dominant signal which is passed to a level conditioner 127 which has a second input being the filtered twice-squared carrier signal $v_6$. The output of the level conditioner 127 is sub-dominant signal $v_{16}$ free of any crosstalk of the dominant carrier, and restored to its normal value.

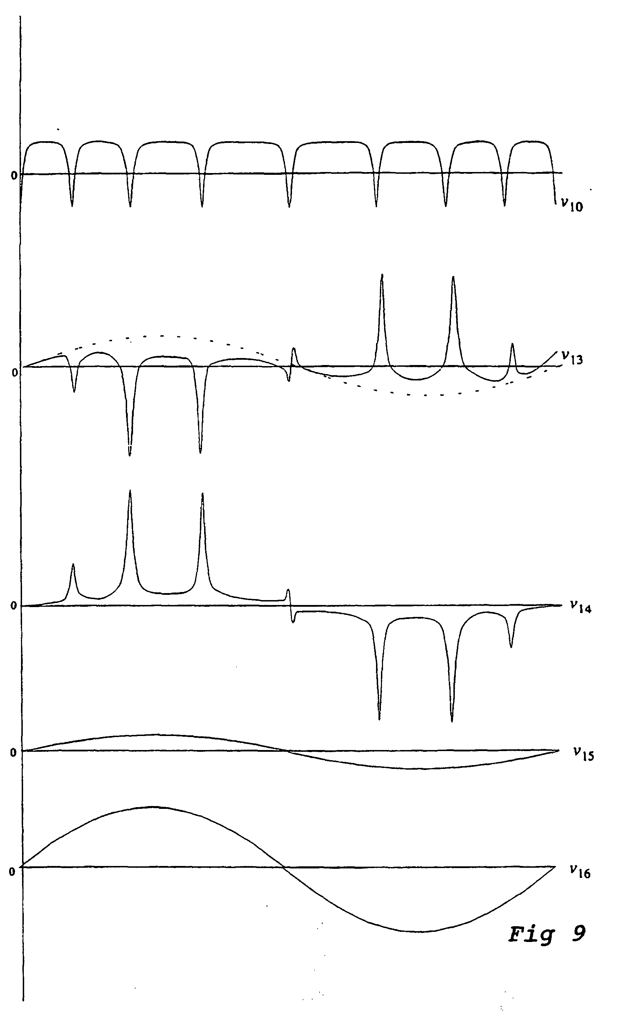

The waveforms for the sub-dominant channel 121 are shown in Fig. 9, when the sub-dominant, wanted signal is modulated.

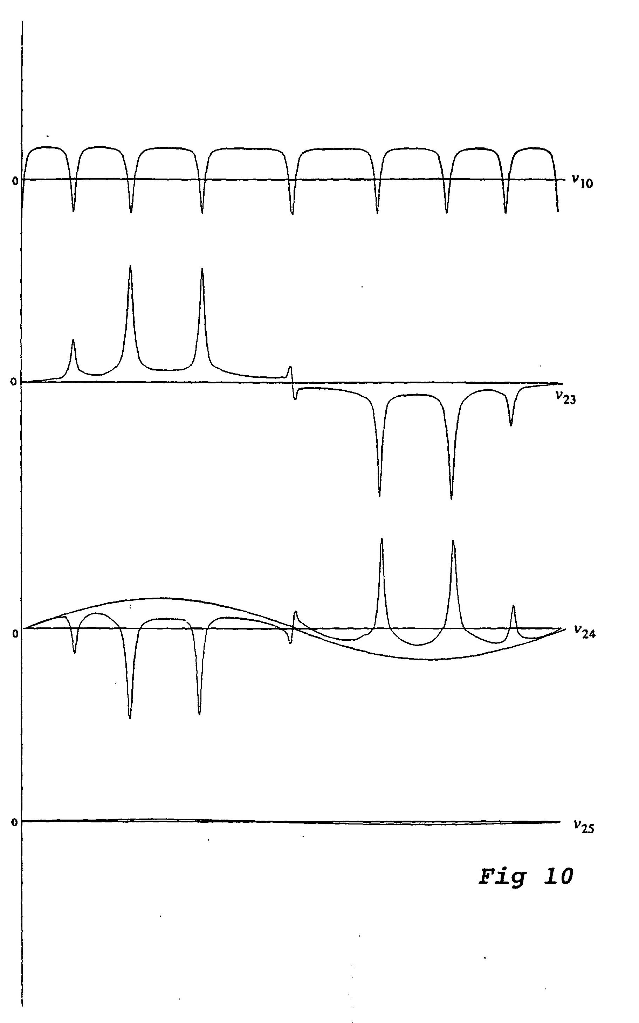

In the case where the dominant, unwanted, signal is modulated, as illustrated in Fig. 10, waveform $v_{23}$ multiplied by signal $v_{10}$ results in suppression of the dominant signal, as illustrated in waveform $v_{25}$.

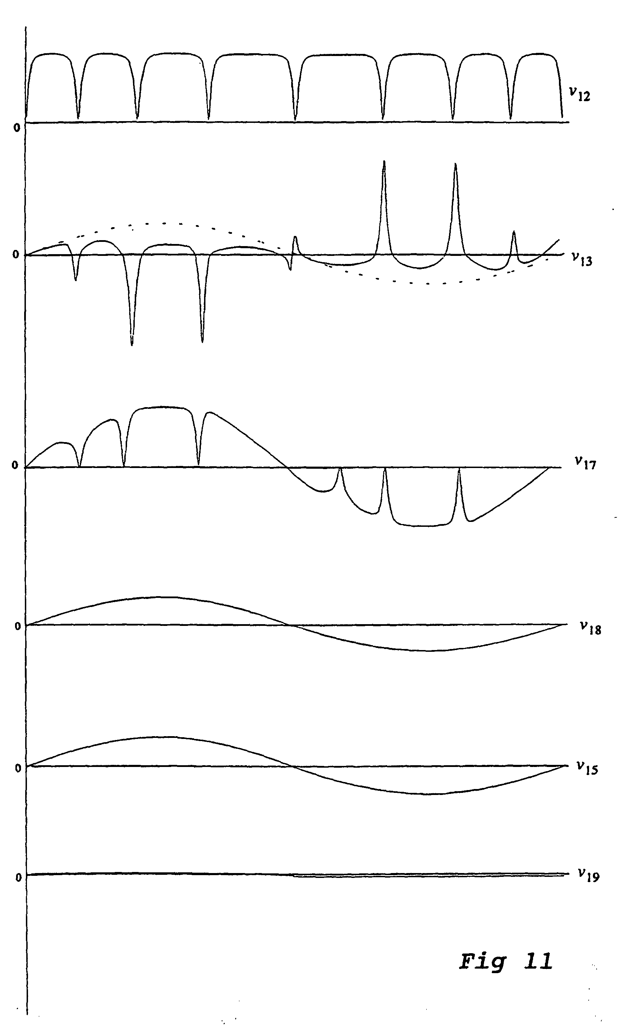

The dominant channel 122 comprises a multiplier 124 fed by signal $v_{12}$ and signal $v_{13}$ to give output $v_{17}$. The output of multiplier 124 ($v_{17}$) is fed to adder 128 through low pass filter 126. A second input to the adder 128 is the signal $v_{15}$ from low pass filter 125 in the subdominant channel 121. The output of the adder 128 is thus the dominant carrier free of any crosstalk from the subdominant carrier. The waveforms for the dominant channel are shown in Fig. 11.

Thus the circuit has two distinct outputs. The first, $v_{16}$, is the recovered subdominant free of any dominant carrier content, and the second, $v_{19}$, is the recovered dominant carrier free of any sub-dominant content.

The circuits of the invention thus provide for the separation of two independently modulated co-channel interfering carrier of similar strength and having the same or similar carrier frequency.

**Claims**

1.  A method for the demodulation of fm signals, the fm signals comprising a wanted carrier signal and an interfering carrier signal, the method comprising the steps of :- generating a first signal ($v_3$) from an initial signal ($v_1$), said

4

first signal ($v_3$) being a function of the ratio (m) of the interfering carrier to the wanted carrier and of the instantaneous difference ($\omega_d$) between the frequency of the wanted carrier and the interfering carrier; generating a second signal ($v_4$) from said first signal ($v_3$) by removing any dc value from said first signal ($v_3$); generating the mathematical square ($v_5$) of said second signal ($v_4$) ; generating a dc value ($v_6$) from said squared signal ($v_5$); generating a numerator function ($v_9$) being a function of said dc value ($v_6$), said second signal ($v_4$) and a dc offset ($v_7$); generating a denominator function ($v_8$) being a function of said first signal ($v_3$) and said dc offset ($v_7$); performing a division process between said numerator function ($v_9$) and said denominator function ($v_8$) to generate a quotient function ($v_{10}$); generating, from said initial signal, a demodulated fm signal ($v_{13}$) being a combination of the wanted carrier signal and the interfering carrier signal; multiplying together said quotient function ($v_{10}$) and said demodulated fm signal ($v_{13}$) to generate a first intermediate output ($v_{14}$); passing said first intermediate output ($v_{14}$) through a low pass filter to generate a first filtered output ($v_{15}$) ; and multiplying said first filtered output ($v_{15}$) by said dc value ($v_6$) to give a first desired output ($v_{16}$).

2. A method as claimed in Claim 1 wherein said first signal ($v_3$) is generated by squaring an initial signal ($v_1$) to give a squared initial signal ($v_2$), and passing said squared initial signal ($v_2$) through a low pass filter (104).

3. A method as claimed in Claim 2 wherein said initial signal ($v_1$) is derived by passing an input co-channel carrier ($v_0$) through an automatic gain control circuit (102).

4. A method as claimed in any preceding Claim wherein said quotient function ($v_{10}$) is generated by dividing said numerator function ($v_9$) by said denominator function ($v_8$) in an Amplitude Locked Loop circuit (110).

5. A method as claimed in either Claim 3 or Claim 4 wherein said demodulated fm signal ($v_{13}$) is generated by passing said initial signal ($v_1$) through a Phase Locked Loop circuit (117).

6. A method as claimed in any preceding claim, including the step of adding a dc voltage ($v_{11}$) to the said quotient function ($v_{10}$) to generate a modified quotient signal ($v_{12}$) .

7. A method as claimed in claim 6, including the step of multiplying said modified quotient signal ($v_{12}$) by said demodulated output ($v_{13}$) to give a second intermediate output ($v_{17}$).

8. A method as claimed in Claim 7, including passing said second intermediate output ($v_{17}$) through a low pass filter (126) to give a second filtered output ($v_{18}$) and subtracting from said second filtered output ($v_{18}$) said first filtered output ($v_{15}$) to give a second desired output ($v_{19}$).

9. A circuit for demodulating FM signals, the FM signals comprising a wanted carrier signal and an interfering carrier signal, the circuit comprising means (102, 103,104) for generating a first signal ($v_3$) from an initial signal ($v_1$), said first signal ($v_3$) being a function of the ratio (m) of the interfering carrier to the wanted carrier and of the instantaneous difference ($\omega_d$) between the frequency of the wanted carrier and the interfering carrier; means (105) for generating a second signal ($v_4$) from said first signal ($v_3$) by removing any dc value from said first signal ($v_3$) ; a squaring circuit (106) for generating the mathematical square ($v_5$) of said second signal ($v_4$); means (107) for generating a dc value ($v_6$) from said squared signal ($v_5$) ; means (109) for generating a numerator function ($v_9$) being a function of said dc value ($v_6$), said second signal ($v_4$) and a dc offset ($v_7$); means (108) for generating a denominator function ($v_8$) being a function of said first signal ($v_3$) and said dc offset ($v_7$); a division circuit (110) for performing a division process between said numerator function ($v_9$) and said denominator function ($v_8$) to generate a quotient function ($v_{10}$); means (117) for generating, from said initial signal, a demodulated fm signal ($v_{13}$) by combining the wanted carrier signal and the interfering carrier signal; a multiplier circuit (123) for multiplying together said quotient function ($v_{10}$) and said demodulated fm signal ($v_{13}$) to generate a first intermediate output ($v_{14}$) ; a low pass filter (125) receiving said first intermediate output ($v_{14}$) as input and providing as output a first filtered output ($v_{15}$); and a multiplier circuit (127) for multiplying said first filtered output ($v_{15}$) by said dc value ($v_6$) to give a first desired output ($v_{16}$) .

10. A circuit as claimed in Claim 9, wherein said means for generating said second signal ($v_4$) from said first signal ($v_3$) is a high pass filter (105) .

11. A circuit as claimed in either of Claims 9 or 10, wherein said means for generating said dc value ($v_6$) is a low pass filter (107).

**12.** A circuit as claimed in any one of Claims 9 to 11, wherein said means for generating said numerator function ($v_9$) is an adder circuit (109).

**13.** A circuit as claimed in any one of Claims 9 to 12, wherein said means for generating said denominator function ($v_8$) is an adder circuit (108).

**14.** A circuit as claimed in any of Claims 9 to 13, wherein said division circuit (110) is an Amplitude Locked Loop Circuit.

**15.** A circuit as claimed in any of claims 9 to 14, wherein said means for generating said demodulated fm signal ($v_{13}$) comprises a Phase Locked Loop circuit (117) .

**Patentansprüche**

**1.** Eine Methode zur Demodulation von FM-Signalen; die FM-Signale bestehen aus einem Nutzträgersignal und einem Störträgersignal; die Methode besteht aus den Schritten: - Generierung eines ersten Signals ($v_3$) aus einem Anfangssignal ($v_1$), wobei das besagte erste Signal ($v_3$) eine Funktion des Verhältnisses (m) des Störträgers zum Nutzträger und der Augenblicksdifferenz ($?_d$) zwischen der Frequenz des Nutzträgers und des Störträgers ist; Generierung eines zweiten Signals ($v_4$) aus dem besagten ersten Signal ($v_3$) durch Entfernung aller Gleichglieder aus dem besagten ersten Signal ($v_3$); Bildung des mathematischen Quadrats ($v_5$) des besagten zweiten Signals ($v_4$); Generierung eines Gleichglieds ($v_6$) aus dem besagten quadrierten Signal ($v_5$); Bildung einer Zählerfunktion ($v_9$), die eine Funktion des besagten Gleichglieds ($v_6$), des besagten zweiten Signals ($v_4$) und eines DC-Offsets ($v_7$) darstellt; Bildung einer Nennerfunktion ($v_8$), die eine Funktion des besagten ersten Signals ($v_3$) und des besagten DC-Offsets ($v_7$) darstellt; Ausführung einer Division zwischen der besagten Zählerfunktion ($v_9$) und der besagten Nennerfunktion ($v_8$), um eine Quotientenfunktion ($v_{10}$) zu bilden; Generierung, aus besagtem Anfangssignal, eines demodulierten FM-Signals ($v_{13}$), das eine Kombination des Nutzträgersignals und des Störträgersignals darstellt; Multiplizierung der besagten Quotientenfunktion ($v_{10}$) mit dem besagten demodulierten FM-Signal ($v_{13}$), um ein erstes Zwischensignal ($v_{14}$) zu generieren; Weiterleitung des besagten ersten Zwischensignals ($v_{14}$) durch einen Tiefpassfilter, um ein erstes gefiltertes Signal ($v_{15}$) zu generieren; und Multiplizierung des besagten ersten gefilterten Signals ($v_{15}$) mit dem besagten Gleichglied ($v_6$), um ein erstes gewünschtes Signal ($v_{16}$) zu erhalten.

**2.** Eine Methode wie in Patentanspruch 1 beansprucht, wobei das besagte erste Signal ($v_3$) durch Quadrierung eines Anfangssignals ($v_1$) generiert wird, um ein quadriertes Anfangssignal zu erhalten ($v_2$), und Weiterleitung des besagten quadrierten Anfangssignals ($v_2$) durch einen Tiefpassfilter (104).

**3.** Eine Methode wie in Patentanspruch 2 beansprucht, wobei das besagte Anfangssignal ($v_1$) **dadurch** entsteht, indem ein Eingangsgleichkanalträger ($v_0$) durch eine automatische Verstärkungsregelungsschaltung (102) geleitet wird.

**4.** Eine Methode wie in allen vorstehenden Patentansprüchen beansprucht, wobei die besagte Quotientenfunktion ($v_{10}$) **dadurch** gebildet wird, indem die besagte Zählerfunktion ($v_9$) durch die besagte Nennerfunktion ($v_8$) in einer Amplitudenregelschleifenschaltung (110) geteilt wird.

**5.** Eine Methode wie entweder in Patentanspruch 3 oder Patentanspruch 4 beansprucht, wobei das besagte demodulierte FM-Signal ($v_{13}$) **dadurch** generiert wird, indem das besagte Anfangssignal ($v_1$) durch eine Phasenregelschleifenschaltung (117) geleitet wird.

**6.** Eine Methode wie in allen vorherstehenden Patentansprüchen beansprucht, inklusive des Schrittes der Hinzufügung einer Gleichspannung ($v_{11}$) zu der besagten Quotientenfunktion ($v_{10}$), um ein modifiziertes Quotientensignal ($v_{12}$) zu generieren.

**7.** Eine Methode wie in Patentanspruch 6 beansprucht, inklusive des Schrittes der Multiplizierung des besagten modifizierten Quotientensignals ($v_{12}$) mit dem besagten demodulierten Signal ($v_{13}$), um ein zweites Zwischensignal ($v_{17}$) zu erhalten.

**8.** Eine Methode wie in Patentanspruch 7 beansprucht, inklusive der Weiterleitung des besagten zweiten Zwischensignals ($v_{17}$) durch einen Tiefpassfilter (126), um ein zweites gefiltertes Signal ($v_{18}$) zu erhalten, und Subtrahierung des besagten ersten gefilterten Signals ($v_{15}$) von dem besagten zweiten gefilterten Signal ($v_{18}$), um ein zweites gewünschtes Signal ($v_{19}$) zu erhalten.

9. Eine Schaltung zur Demodulation von FM-Signalen; die FM-Signale bestehen aus einem Nutzträgersignal und einem Störträgersignal; die Schaltung besteht aus Hilfsmitteln (102, 103, 104) zur Generierung eines ersten Signals ($v_3$) aus einem Anfangssignal ($v_1$), wobei das besagte erste Signal ($v_3$) eine Funktion des Verhältnisses (m) des Störträgers zum Nutzträger und der Augenblicksdifferenz ($?_d$) zwischen der Frequenz des Nutzträgers und des Störträgers ist; Hilfsmitteln (105) zur Generierung eines zweiten Signals ($v_4$) aus dem besagten ersten Signal ($v_3$) durch Entfernung aller Gleichglieder aus dem besagten ersten Signal ($v_3$); einer Quadrierschaltung (106) zur Bildung des mathematischen Quadrats ($v_5$) des besagten zweiten Signals ($v_4$); Hilfsmitteln (107) zur Generierung eines Gleichglieds ($v_6$) aus dem besagten quadrierten Signal ($v_5$); Hilfsmittel (109) zur Bildung einer Zählerfunktion ($v_9$), die eine Funktion des besagten Gleichglieds ($v_6$), des besagten zweiten Signals ($v_4$) und eines DC-Offsets ($v_7$) darstellt; Hilfsmittel (108) zur Bildung einer Nennerfunktion ($v_8$), die eine Funktion des besagten ersten Signals ($v_3$) und des besagten DC-Offsets ($v_7$) darstellt; einer Divisionsschaltung (110) zur Ausführung einer Division zwischen der besagten Zählerfunktion ($v_9$) und der besagten Nennerfunktion ($v_8$), um eine Quotientenfunktion ($v_{10}$) zu bilden; Hilfsmittel (117) zur Generierung, aus besagtem Anfangssignal, eines demodulierten FM-Signals ($v_{13}$) durch die Kombination des Nutzträgersignals mit dem Störträgersignal; einer Multiplizierungsschaltung (123) zur Multiplizierung der besagten Quotientenfunktion ($v_{10}$) mit dem besagten demodulierten FM-Signal ($v_{13}$), um ein erstes Zwischensignal ($v_{14}$) zu generieren; einem Tiefpassfilter (125), der das besagte erste Zwischensignal ($v_{14}$) als Eingangssignal erhält und ein erstes gefiltertes Signal ($v_{15}$) als Ausgangssignal wieder ausgibt; und einer Multiplizierungsschaltung (127) zur Multiplizierung des besagten ersten gefilterten Signals ($v_{15}$) mit dem besagten Gleichglied ($v_6$), um ein erstes gewünschtes Signal ($v_{16}$) zu erhalten.

10. Eine Schaltung wie in Patentanspruch 9 beansprucht, bei der das besagte Hilfsmittel zur Generierung des besagten zweiten Signals ($v_4$) aus dem besagten ersten Signal ($v_3$) ein Hochpassfilter (105) ist.

11. Eine Schaltung wie entweder in Patentanspruch 9 oder Patentanspruch 10 beansprucht, bei der das besagte Hilfsmittel zur Generierung des besagten Gleichglieds ($v_6$) ein Tiefpassfilter (107) ist.

12. Eine Schaltung wie in einem der Patentansprüche 9 bis 11 beansprucht, bei der das besagte Hilfsmittel zur Generierung der besagten Zählerfunktion ($v_9$) eine Additionsschaltung (109) ist.

13. Eine Schaltung wie in einem der Patentansprüche 9 bis 12 beansprucht, bei der das besagte Hilfsmittel zur Generierung der besagten Nennerfunktion ($v_8$) eine Additionsschaltung (109) ist.

14. Eine Schaltung wie in einem der Patentansprüche 9 bis 13 beansprucht, bei der das besagte Hilfsmittel zur Generierung der besagten Divisionsschaltung (110) eine Amplitudenregelschleifenschaltung ist.

15. Eine Schaltung wie in einem der Patentansprüche 9 bis 14 beansprucht, bei der das besagte Hilfsmittel zur Generierung des besagten demodulierten FM-Signals ($v_{13}$) eine Phasenregelschleifenschaltung (117) beinhaltet.

**Revendications**

1. Procédé permettant la démodulation de signaux modulés en fréquence, les signaux modulés en fréquence comprenant un signal de porteuse utile et un signal de porteuse parasite, le procédé comprenant les étapes suivantes : la génération d'un premier signal ($v_3$) à partir d'un signal initial ($v_1$), ledit premier signal ($v_3$) étant une fonction du rapport (m) du signal de porteuse parasite au signal de porteuse utile et de la différence instantanée ($\omega_d$) entre la fréquence du signal de porteuse utile et du signal de porteuse parasite ; la génération d'un deuxième signal ($v_4$) à partir dudit premier signal ($v_3$) en retirant une valeur continue quelconque dudit premier signal ($v_3$) ; la génération du carré mathématique ($v_5$) dudit deuxième signal ($v_4$) ; la génération d'une valeur continue ($v_6$) à partir dudit signal au carré ($v_5$) ; la génération d'une fonction de numérateur ($v_9$) qui est une fonction de ladite valeur continue ($v_6$), dudit deuxième signal ($v_4$) et d'un décalage du niveau continu ($v_7$) ; la génération d'une fonction de dénominateur ($v_8$) qui est une fonction dudit premier signal ($v_3$) et dudit décalage du niveau continu ($v_7$) ; l'exécution d'un processus de division entre ladite fonction de numérateur ($v_9$) et ladite fonction de dénominateur ($v_8$) pour générer une fonction de quotient ($v_{10}$) ; la génération, à partir dudit signal initial, d'un signal modulé en fréquence démodulé ($v_{13}$) qui est une combinaison du signal de porteuse utile et du signal de porteuse parasite ; la multiplication de ladite fonction de quotient ($v_{10}$) par ledit signal modulé en fréquence démodulé ($v_{13}$) pour générer une première

sortie intermédiaire ($v_{14}$) ; l'application de ladite première sortie intermédiaire ($v_{14}$) dans un filtre passe-bas pour générer une première sortie filtrée ($v_{15}$), et la multiplication de ladite première sortie filtrée ($v_{15}$) par ladite valeur continue ($v_6$) pour donner une première sortie souhaitée ($v_{16}$).

2. Procédé suivant la revendication 1, dans lequel ledit premier signal ($v_3$) est généré en mettant au carré un signal initial ($v_1$) pour donner un signal initial au carré ($v_2$), et l'application dudit signal initial au carré ($v_2$) dans un filtre passe-bas (104).

3. Procédé suivant la revendication 2, dans lequel ledit signal initial ($v_1$) est dérivé en appliquant une porteuse dans un même canal d'entrée ($v_0$) dans un circuit de commande automatique de gain (102).

4. Procédé suivant l'une quelconque des revendications précédentes, dans lequel ladite fonction de quotient ($v_{10}$) est générée en divisant ladite fonction de numérateur ($v_9$) par ladite fonction de dénominateur ($v_8$) dans un circuit à boucle à verrouillage d'amplitude (110).

5. Procédé suivant la revendication 3 ou 4, dans lequel ledit signal modulé en fréquence démodulé ($v_{13}$) est généré en appliquant ledit signal initial ($v_1$) dans un circuit à boucle à verrouillage de phase (117).

6. Procédé suivant l'une quelconque des revendications précédentes, comprenant l'étape de l'addition d'une tension continue ($v_{11}$) à ladite fonction de quotient ($v_{10}$) pour générer un signal de quotient modifié ($v_{12}$).

7. Procédé suivant la revendication 6, comprenant l'étape de la multiplication dudit signal de quotient modifié ($v_{12}$) par ladite sortie démodulée ($v_{13}$) pour donner une deuxième sortie intermédiaire ($v_{17}$).

8. Procédé suivant la revendication 7, comprenant l'application de ladite deuxième sortie intermédiaire ($v_{17}$) dans un filtre passe-bas (126) pour donner une deuxième sortie filtrée ($v_{18}$) et la soustraction de ladite première sortie filtrée ($v_{15}$) de ladite deuxième sortie filtrée ($v_{18}$) pour donner une deuxième sortie souhaitée ($v_{19}$).

9. Circuit pour démoduler des signaux modulés en fréquence, les signaux modulés en fréquence comprenant un signal de porteuse utile et un signal de porteuse parasite, le circuit comprenant des moyens (102, 103, 104) pour générer un premier signal ($v_3$) à partir d'un signal initial ($v_1$), ledit premier signal ($v_3$) étant une fonction du rapport (m) du signal de porteuse parasite au signal de porteuse utile et de la différence instantanée ($\omega_d$) entre la fréquence du signal de porteuse utile et du signal de porteuse parasite ; un moyen (105) pour générer un deuxième signal ($v_4$) à partir dudit premier signal ($v_3$) en retirant une valeur continue quelconque dudit premier signal ($v_3$) ; un circuit de mise au carré (106) pour générer le carré mathématique ($v_5$) dudit deuxième signal ($v_4$) ; un moyen (107) pour générer une valeur continue ($v_6$) à partir dudit signal au carré ($v_5$) ; un moyen (109) pour générer une fonction de numérateur ($v_9$) qui est une fonction de ladite valeur continue ($v_6$), dudit deuxième signal ($v_4$) et d'un décalage du niveau continu ($v_7$) ; un moyen (108) pour générer une fonction de dénominateur ($v_8$) qui est une fonction dudit premier signal ($v_3$) et dudit décalage du niveau continu ($v_7$) ; un circuit de division (110) pour exécuter un processus de division entre ladite fonction de numérateur ($v_9$) et ladite fonction de dénominateur (v8) pour générer une fonction de quotient ($v_{10}$) ; un moyen (117) pour générer, à partir dudit signal initial, un signal modulé en fréquence démodulé ($v_{13}$) en combinant le signal de porteuse utile et le signal de porteuse parasite ; un circuit de multiplication (123) pour multiplier ladite fonction de quotient ($v_{10}$) par ledit signal modulé en fréquence démodulé ($v_{13}$) pour générer une première sortie intermédiaire ($v_{14}$) ; un filtre passe-bas (125) recevant ladite première sortie intermédiaire ($v_{14}$) comme entrée et fournissant comme sortie une première sortie filtrée ($v_{15}$), et un circuit de multiplication (127) pour multiplier ladite première sortie filtrée ($v_{15}$) par ladite valeur continue ($v_6$) pour donner une première sortie souhaitée ($v_{16}$).

10. Circuit suivant la revendication 9, dans lequel ledit moyen pour générer ledit deuxième signal ($v_4$) à partir dudit premier signal ($v_3$) est un filtre passe-haut (105).

11. Circuit suivant la revendication 9 ou 10, dans lequel ledit moyen pour générer ladite valeur continue ($v_6$) est un filtre passe-bas (107).

12. Circuit suivant l'une quelconque des revendications 9 à 11, dans lequel ledit moyen pour générer ladite fonction de numérateur ($v_9$) est un circuit d'addition (109).

13. Circuit suivant l'une quelconque des revendications 9 à 12, dans lequel ledit moyen pour générer ladite fonction

de dénominateur ($v_8$) est un circuit d'addition (108).

14. Circuit suivant l'une quelconque des revendications 9 à 13, dans lequel ledit circuit de division (110) est un circuit à boucle à verrouillage d'amplitude.

15. Circuit suivant l'une quelconque des revendications 9 à 14, dans lequel ledit moyen pour générer ledit signal modulé en fréquence démodulé ($v_{13}$) comprend un circuit à boucle à verrouillage de phase (117).

$v_o$

$101$

$102$

$1.0$

$\dfrac{K}{s\tau}$

$v_1$

$*$

$v_2$

LPF

$v_3$

$104$

$103$

*Fig 1*

$v_3 \longrightarrow$

$+$
$+$

$\longrightarrow v_8$

$108$

$v_7$

*Fig 2*

$v_3 \longrightarrow$ HPF

$105$

$v_4$

$*$

$106$

$v_5$

LPF

$107$

$v_6$

$+$
$+$
$-$

$v_4$

$v_9$

$109$

$v_7$

*Fig 3*

Fig 4

Fig 5

Fig 6

*Fig 7*

*Fig 8*

Fig 9

Fig 10

*Fig 11*